(19) Europäisches Patentamt

European Patent Office

Office européen des brevets

(11) **EP 0 612 147 B1**

(12) **EUROPÄISCHE PATENTSCHRIFT**

(45) Veröffentlichungstag und Bekanntmachung des Hinweises auf die Patenterteilung:
**28.06.2006 Patentblatt 2006/26**

(51) Int Cl.:
***H03H 17/02*** *(2006.01)*

(21) Anmeldenummer: **94101674.3**

(22) Anmeldetag: **04.02.1994**

(54) **Digitaler Filterbaustein**

Digital filter building block

Elément de filtre numérique

(84) Benannte Vertragsstaaten:
**AT CH DE ES FR GB IT LI NL**

(30) Priorität: **19.02.1993 DE 4305075**

(43) Veröffentlichungstag der Anmeldung:
**24.08.1994 Patentblatt 1994/34**

(73) Patentinhaber: **Marconi Communications GmbH
71522 Backnang (DE)**

(72) Erfinder: **Göckler, Heinz Dr.
D-71522 Backnang (DE)**

(74) Vertreter: **Pellkofer, Dieter
Manitz, Finsterwald & Partner GbR
Postfach 31 02 20
80102 München (DE)**

(56) Entgegenhaltungen:
**US-A- 4 698 680**

- **1992 IEEE INTERNATIONAL SYMPOSIUM ON CIRCUITS AND SYSTEMS, Bd.3, 10. Mai 1992, SAN DIEGO Seiten 1348 - 1351, XP000338199 R. HAWLEY ET AL. 'A SILICON COMPILER FOR HIGH-SPEED CMOS MULTIRATE FIR DIGITAL FILTERS'**
- **IEEE TRANSACTIONS ON INSTRUMENTATION AND MEASUREMENT, Bd.IM-36, Nr.4, Dezember 1987, NEW YORK US Seiten 979 - 982, XP000032389 P.S. TANG ET AL. 'APPLICATIONS OF A MULTICHANNEL DIGITAL WAVEFORM RECORDER AND SWITCHABLE SAMPLING RATE'**

**Beschreibung**

In digitalen Signalverarbeitungs- und Übertragungssystemen sind oft vielfältige Filteraufgaben zu erfüllen. Dabei sind unterschiedliche Filterfunktionen zu realisieren, beispielsweise: Veränderung der Abtastfrequenz von Signalen oder Umwandlung von reellen Signalen in komplexwertige und umgekehrt oder Trennung/Zusammenfassung von Signalen verschiedener Frequenzen (Frequenzweiche).

Bisher war es üblich, für jede dieser Filterfunktionen eine eigene Schaltung zu entwickeln. Man mußte daher eine Vielzahl unterschiedlicher Filterbausteine entwickeln und fertigen.

Ein digitaler Filterbaustein gemäß dem Oberbegriff des Anspruchs 1 bzw. 2 ist aus dem Aufsatz von R. Hawley et al, "A Silicon Compiler for High-Speed CMOS Multirate FIR Digital Filters" in 1992 IEEE International Symposium on Circuits and Systems, Bd. 3,5. 1348-1351, XP000338199, bekannt.

Der Erfindung liegt die Aufgabe zugrunde, einen digitalen Filterbaustein anzugeben, mit dem sich der Aufwand für die Realisierung vieler verschiedener Filterfunktionen möglichst weitgehend verringert.

Erfindungsgemäß wird diese Aufgabe durch die Merkmale des Anspruchs 1 bzw. 2 gelöst. Zweckmäßige Weiterbildungen der Erfindung gehen aus den Unteransprüchen hervor.

Anhand eines in der Zeichnung dargestellten Ausführungsbeispiels wird nun die Erfindung näher erläutert.

Fig. 1     zeigt ein Blockschaltbild eines Filterbausteins,

Fig. 2     zeigt ein Eingangsnetzwerk und

Fig. 3     ein Ausgangsnetzwerk in dem Filterbaustein.

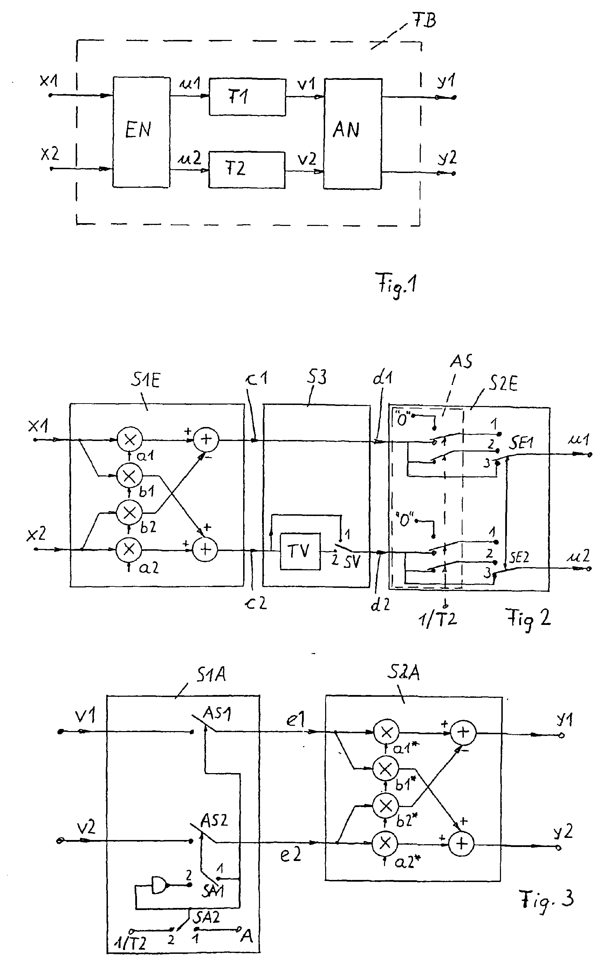

Der Fig. 1 ist ein Blockschaltbild eines digitalen Filterbausteins FB zu entnehmen, der so konzipiert ist, daß mit ihm wahlweise mehrere verschiedene Filterfunktionen erzeugt werden können. Dieser Filterbaustein besteht aus mehreren (im Ausführungsbeispiel zwei) Zweigfiltern F1, F2, welche vorzugsweise nichtrekursive FIR-Filter (Filter mit begrenzter Impulsantwort) sind. Die Zweigfilter F1, F2 sind gleichartig aufgebaut und erzeugen unabhängig voneinander aus den ihnen von einem Eingangsnetzwerk EN zugeführten Signalen u1, u2 Eingangssignale v1, v2 für ein nachfolgendes Ausgangsnetzwerk AN. Das Eingangs- und das Ausgangsnetzwerk EN und AN verarbeiten die ihnen zugeführten Signale so, daß von den Eingangssignalen x1, x2 Ausgangssignale y1, y2 entstehen, die einer vorgegebenen Filterfunktion entsprechen. Damit wahlweise verschiedene Filterfunktionen mit dem Filterbaustein FB realisiert werden können, sind die Signalverarbeitungsfunktionen des Eingangs- und Ausgangsnetzwerkes EN, AN veränderbar.

Wie Fig. 2 zeigt, besteht das Eingangsnetzwerk EN aus drei kaskadierten Schaltungsteilen S1E, S2E und S3. Der erste Schaltungsteil S1E enthält ein Verknüpfungsnetzwerk, das folgende Ausgangssignale c1 (kT1) und c2(kT1) aus den ihm zugeführten Eingangssignalen x1(kT1) und x2(kT1) bildet:

$$c1(kT1) = a1 \cdot x1(kT1) \mp b2 \cdot x2(kT1)$$
$$c2(kT1) = a2 \cdot x2(kT1) \pm b1 \cdot x1(kT1), \qquad (1)$$

wobei a1, a2, b1, b2 veränderbare Parameter des Verknüpfungsnetzwerks sind, T1 das Abtastintervall der Eingangssignale und k ein laufender Zeitindex ist.

Um diese in (1) angegebenen Funktionen realisieren zu können, besteht der erste Schaltungsteil S1E aus vier Multiplizierern, welche die Produkte aus den Eingangssignalen x1, x2 und den Parametern a1, a2, b1, b2, bilden, und zwei die einzelnen Produkte addierenden Summierern.

Der zweite Schaltungsteil S2E weist eine Abtastschaltung AS auf, die in beiden Schaltungszweigen mehrere mit einem Abtasttakt 1/T2 gleichangesteuerte Schalter besitzt. Weiterhin ist in jedem Schaltungszweig ein Schalter SE1, SE2 vorhanden, der zwischen drei Schaltstellungen 1, 2, 3, von denen jede einem anderen Abtasttakt der Abtastschaltungs AS zugeordnet ist, wählen kann. In der Schaltstellung 3 behalten die Ausgangssignale u1, u2 den Abtasttakt 1/T1 der Eingangssignale d1, d2 bei (T2=T1). In der Schalterstellung 2 ist das Abtastintervall T der Ausgangssignale u1, u2 gleich dem doppelten Abtastintervall T1 der Eingangssignale d1, d2 (T2=2T1). Und in der Schalterstellung 1 ist das Abtastintervall T der Ausgangssignale u1, u2 gleich dem halben Abtastintervall T1 der Eingangssignale d1, d2 (T2=T1/2). Der zweite Schaltungsteil S2E ermöglicht es also, ggf. die Abtastfrequenz der den Zweigfilter F1, F2 zugeführten Signale u1, u2 zu verändern.

Wie Fig. 2 zeigt, ist zwischen dem ersten S1E und zweiten Schaltungsteil S2E noch ein weiterer Schaltungsteil S3 eingefügt, der aber ebenso in dem Ausgangsnetzwerk zwischen dem ersten S1A und zweiten Schaltungsteil S2A einsetzbar ist. Dieser Schaltungsteil S3 weist in einem Schaltzweig ein überbrückbares Verzögerungsglied TV auf. Die Verzögerungszeit des Verzögerungsgliedes TV entspricht einem Abtastintervall T1 der Eingangssignale c1, c2. Mit dem Schalter SV kann das Verzögerungsglied TV eingeschaltet (Schaltstellung 2) oder überbrückt werden (Schalterstellung 1).

Ein Ausführungsbeispiel für das Ausgangsnetzwerk AN ist in Fig. 3 dargestellt. Es besteht aus einem ersten Schaltungsteil S1A und einem damit kaskadierten zweiten Schaltungsteil S2A.

Der erste Schaltungsteil S1A ist eine Abtastschaltung, mit der die Abtastfrequenz der Eingangssignale v1, v2 - das sind die Ausgangssignale der Zweigfilter F1, F2 - veränderbar ist. Die Abtastschalter AS1 und AS2 in den beiden Schaltzweigen sind über Schalter SA1 und SA2 entweder an einen Abtasttakt 1/T2 oder an ein konstantes Steuersignal A schaltbar, das beide Abtastschalter AS1 und AS2 geschlossen hält, solange es anliegt. Die möglichen Funktionen der Abtastschaltung des ersten Schaltungsteils S1A sind folgende:

1. Bei Stellung 1 des Schalters SA2 und Stellung 1 des Schalters SA1 erhalten die Ausgangssignale e1, e2 einen Abtasttakt 1/T2 der gleich dem Abtasttakt 1/T der Eingangssignale v1, v2 ist (T2=T).

2. Bei Stellung 2 des Schalters SA2 und Stellung 1 des Schalters SA1 schließen/öffnen beide Abtastschalter AS1 und $AS_2$ gleichphasig synchron, und die Ausgangssignale e1, e2 erhalten einen Abtasttakt 1/T2, der gleich dem halben Abtasttakt 1/T der Eingangssignale v1, v2 ist (T2=2T).

3. Bei Stellung 2 des Schalters SA1 und Stellung 2 des Schalters SA2 schließen/öffnen die Abtastschalter AS1 und AS2 gegenphasig synchron. Dadurch erhalten die Ausgangssignale e1, e2 einen Abtasttakt 1/T2, der dem doppelten Abtasttakt 1/T der Eingangssignale v1, v2 entspricht (T2=T/2). Der zweite Schaltungsteil S2A - er ist ähnlich aufgebaut wie der erste Schaltungsteil des Eingagsnetzwerkes - enthält ein Verknüpfungsnetzwerk, das folgende Ausgangssignale y1(kT2) und y2(kT2) aus den ihnen zugeführten Eingangssignalen e1(kT2) und e2(kT2) bildet:

$$y1(kT2) = a1^* \cdot e1(kT2) \mp b2^* \cdot e2(kT2)$$
$$y2(kT2) = a2^* \cdot e2(kT2) \pm b1^* \cdot e1(kT2), \qquad (2)$$

wobei a1*, a2*, b1*, b2* veränderbare Parameter des Verknüpfungsnetzwerks sind, T2 das Abtastintervall der Eingangssignale und k ein laufender Zeitindex ist.

Um diese in (2) angegebenen Funktionen realisieren zu können, besteht der zweite Schaltungsteil S2A aus vier Multiplizierern, welche die Produkte aus den Eingangssignalen e1, e2 und den Parametern a1* a2*, b1*, b2* bilden, und zwei die einzelnen Produkte addierenden/subtrahierenden Summierern.

Die in den Verknüpfungsnetzwerken der Ein- EN und Ausgangsschaltung AN vorkommenden veränderbaren Parameter a1, a2, a1*, a2*, b1, b2, b1*, b2* können die Werte 0, 1 oder -1 annehmen. Für eine Verschiebung der Frequenz (z.B. Mittenfrequenz) der Signale am Filtereingang um eine Frequenz $f_0$ erhalten die Parameter a1, a2, b1, b2 folgende Werte:

$$a1 = a2 = a(kT1)$$

$$b1 = b2 = b(kT1),$$

wobei

$$a(kT1) = \cos(2\pi k f_0 / f_{AE})$$

$$b(kT1) = \pm \sin(2\pi k f_0 / f_{AE}).$$

Für eine Verschiebung der Frequenz (z.B. Mittenfrequenz) der Signale am Filterausgang um eine Frequenz $f_0^*$ erhalten die Parameter a1*, a2*, b1*, b2* folgende Werte ($f_{AA}$=1/T2):

$$a1^* \ = \ a2^* \ = \ a^*(kT2)$$

$$b1^* \ = \ b2^* \ = \ b^*(kT2)$$

wobei

$$a^*(kT2) \ = \ \cos(2\pi kf_0^*/f_{AA})$$

$$b^*(kT2) \ = \pm \ \sin(2\pi kf_0^*/f_{AA}).$$

Nachfolgend werden einige mit den zuvor beschriebenen Netzwerken realisierbare Filterfunktionen erläutert:
Es soll z .B. ein reelles Eingangssignal x1 gefiltert werden und dabei ein reelles Ausgangssignal y1 entstehen, dessen Abtastfrequenz $f_{AA}$ = 1/T2 doppelt so groß wie die Abtastfrequenz $f_{AE}$ = 1/T1 des Eingangssignals ist. Es gilt also für die Abtastintervalle: T2 = T1/2.
Am Eingangsnetzwerk EN liegt nur das Eingangssignal x1 (x2 = 0) an.
Das Eingangs- EN und das Ausgangsnetzwerk AN sind so zu schalten, daß zwischen deren Ein- und Ausgangssignalen beispielsweise folgende Beziehungen gelten:

$$u1(kT1) \ = \ u2(kT1) \ = \ x1(kT1)$$

und

$$y1(2kT2) \ = \ v1(kT1)$$

$$y1[(2k\pm1)\ T2] \ = \ v2(kT1).$$

Für diesen Fall sind die Parameter beispielsweise so zu wählen:

a1 = b1 = 1 und a2, b2 beliebig, da x2(kT1) = 0
a1* = - b2* = 1 oder a2* = b1* = 1, falls der Ausgang y2 verwendet wird.

Im Eingangsnetzwerk hat der Schalter SV die Stellung 1, die Schalter SE1 und SE2 haben die Stellung 3 und die Schalter SA2 und SA1 im Ausgangsnetzwerk AN haben die Stellung 2 einzunehmen.
Gemäß einem zweiten Beispiel soll mit dem Filterbaustein ein reelles Eingangssignal x1 in ein komplexwertiges Ausgangssignal y1, y2 umgewandelt werden, wobei die Filtermittenfrequenz bei 1/(4T) oder bei 3/(4T) liegt. Für die Abtastintervalle gilt: T1 = T2 = T.
Das Eingangs- EN und das Ausgangsnetzwerk AN sind so zu schalten, daß zwischen deren Ein- und Ausgangssignalen folgende Beziehungen gelten:

$$u1(kT) \ = \ x1(kT)$$

$$u2(kT) \ = \ x1[(k-1)T]$$

$$y1(kT) \ = \ v1(kT): \ Real \ (oder \ Imaginär) - Teil$$

$$y2(kT) = v2(kT): \text{ Imaginär (oder Real) - Teil.}$$

Für diesen Fall sind die Parameter so zu wählen:

a1 = b1 = 1 und a2, b2 beliebig, da x2(kT) = 0
a1* = a2* = 1 und b1* = b2* = 0.

Im Eingangsnetzwerk EN hat der Schalter SV die Stellung 2 und die Schalter SE1, SE2 haben die Stellung 3 und im Ausgangsnetzwerk AN haben die Schalter SA1 und SA2 die Stellung 1 einzunehmen.

In einem dritten Beispiel soll eine Frequenzweiche zur Trennung eines reellen Eingangssignals x1 in zwei reelle Ausgangssignale y1, y2 realisiert werden, wobei die Abtastfrequenz $f_{AA}$ = 1/T2 der Ausgangssignale auf die halbe Abtastfrequenz ½ $f_{AE}$ = 1/2T1 des Eingangssignals dezimiert werden soll. Für die Abtastintervalle gilt also: T2 = 2T1.

Das Eingangs- EN und Ausgangsnetzwerk AN sind so zu schalten, daß zwischen deren Ein- und Ausgangssignalen folgende Beziehungen gelten:

$$u1(kT2) = x1(2kT1)$$

$$u2(kT2) = x1[(2k\pm1) T1]$$

$$y1(kT2) = y1(2kT1) = v1(kT2) \pm v2(kT2)$$

$$y2(kT2) = y2(2kT1) = v1(kT2) \mp v2(kT2)$$

Für diesen Fall sind die Parameter so zu wählen:

a1 = b1 = 1 und a2, b2 beliebig, da x2 - 0
a1* = ∓ b1* = a2* = ∓ b2* = 1.

Im Eingangsnetzwerk EN haben der Schalter SV und die Schalter SE1, SE2 die Stellung 2, und im Ausgangsnetzwerk AN haben die Schalter SA1 und SA2 die Stellung 1 einzunehmen.

In einem vierten Beispiel soll ein komplexwertiges Eingangssignal mit dem Real (Imaginär)-Teil x1 und dem Imaginär (Real)-Teil x2 gefiltert und in der Frequenz um $f_0$ verschoben werden. Für die Abtastintervalle gilt: T1 = T2 = T.

Das Eingangs- EN und das Ausgangsnetzwerk AN sind so zu schalten, daß zwischen deren Eingangs- und Ausgangsnetzwerken folgende Beziehungen bestehen:

$$u1(kT) = a(kT) \cdot x1(kT) \mp b(kT) \cdot x2(kT)$$

$$u2(kT) = a(kT) \cdot x2(kT) \pm b(kT) \cdot x1(kT)$$

mit den Parametern im Eingangsnetzwerk EN:

$$a1(kT) = a2(kT) = a(kT) = \cos(2\pi k f_0 T)$$

$$b1(kT) = b2(kT) = b(kT) = \pm \sin(2\pi k f_0 T)$$

($f_0$: Frequenzverschiebung)

$$y1(kT) = v1(kT) \quad \text{Real (Imaginär)-Teil}$$

$$y2(kT) = v2(kT) \quad \text{Imaginär (Real)-Teil}$$

mit den Parametern im Ausgangsnetzwerk AN:

$$a1^* = a2^* = 1 \text{ und } b1^* = b2^* = 0.$$

Im Eingangsnetzwerk EN hat der Schalter SV die Stellung 1, und die Schalter SE1, SE2 haben die Stellung 3 und im Ausgangsnetzwerk AN haben die Schalter SA1 und SA2 die Stellung 1 einzunehmen.

Die vorangehend beschriebenen Filterfunktionen sind beispielhaft nur einige von sehr vielen Filterfunktionen, die mit dem einen Filterbaustein realisiert werden können.

Der Filterbaustein gemäß der Erfindung kann mit Signaleingängen und -ausgängen versehen werden, damit darüber für bestimmte Anwendungenszwecke weitere Filterbausteine in Kaskade schaltbar sind.

Es ist zweckmäßig, wenn die Zweigfilter, das Eingangs- und das Ausgangsnetzwerk im Zeitmultiplex auf mehrere verschiedene Signale bzw. Kanäle umschaltbar sind.

Falls die Zweigfilter (F1, F2) als FIR-Filter realisiert werden und dabei symmetrische Koeffizienten aufweisen (entsprechend linearer Phase), ist es zweckmäßig, durch Ausnutzung der Koeffizientensymmetrie Multiplizierer einzusparen.

## Patentansprüche

1. Digitaler Filterbaustein mit mehreren digitalen Zweigfiltern (F1, F2), welchen ein digitales Eingangsnetzwerk (EN) vorgeschaltet und ein digitales Ausgangsnetzwerk (AN) nachgeschaltet ist, wobei das Eingangsnetzwerk (EN) auf ein oder mehrere Eingangssignale (x1, x2) so einwirkt, daß daraus die Zweigfilter (F1, F2) und das anschließende Ausgangsnetzwerk (AN) Ausgangssignale (y1, y2) generieren, die einer von mehreren möglichen Filterfunktionen - beispielsweise: Veränderungen der Abtastfrequenz der Eingangssignale, Umwandlung von reellen Eingangssignalen in komplexwertige Ausgangssignale und umgekehrt, Trennung oder Zusammensetzung von Eingangssignalen unterschiedlicher Frequenzen (Filterweiche) - entsprechen, wobei die Zweigfilter (F1, F2) unabhängig voneinander aus den vom Eingangsnetzwerk (EN) gelieferten Signalen (u1, u2) die Eingangssignale für das Ausgangsnetzwerk (AN) erzeugen und wobei die Signalverarbeitungsfunktionen des Eingangs- (EN) und des Ausgangsnetzwerkes (AN) je nach der zu realisierenden Filterfunktion veränderbar sind, **dadurch gekennzeichnet, daß** das Eingangsnetzwerk (EN) zwei kaskadierte Schaltungsteile (S1E, S2E) aufweist, daß der erste Schaltungsteil (S1E) ein Verknüpfungsnetzwerk mit folgender Funktion enthält:

$$c1(kT1) = a1 \cdot x1(kT1) \mp b2 \cdot x2(kT1)$$

$$c2(kT1) = a2 \cdot x2(kT1) \pm b1 \cdot x1(kT1),$$

wobei x1(kT1) und x2(kT1) die Eingangssignale und c1(kT1) und c2(kT1) die Ausgangssignale des Verknüpfungsnetzwerkes sind, a1, a2, b1, b2 veränderbare Parameter sind, mit denen die jeweilige Filterfunktion einstellbar ist, $T_1$ das Abtastintervall der Eingangssignale und k ein laufender Zeitindex ist, und daß der zweite Schaltungsteil (S2E) eine Abtastschaltung aufweist, mit der die Abtastfrequenz der den Zweigfiltern (F1, F2) zugeführten Signale (u1, u2) veränderbar ist.

2. Digitaler Filterbaustein mit mehreren digitalen zweigfiltern (F1, F2), welchen ein digitales Eingangsnetzwerk (EN) vorgeschaltet und ein digitales Ausgangsnetzwerk (AN) nachgeschaltet ist, wobei das Eingangsnetzwerk (EN) auf ein oder mehrere Eingangssignale (x1, x2) so einwirkt, daß daraus die Zweigfilter (F1, F2) und das anschließende Ausgangsnetzwerk (AN) Ausgangssignale (y1, y2) generieren, die einer von mehreren möglichen Filterfunktionen - beispielsweise: Veränderungen der Abtastfrequenz der Eingangssignale, Umwandlung von reellen Eingangssignalen in komplexwertige Ausgangssignale und umgekehrt, Trennung oder Zusammensetzung von Eingangssignalen unterschiedlicher Frequenzen (Filterweiche) - entsprechen, wobei die Zweigfilter (F1, F2) unabhängig voneinander aus den vom Eingangsnetzwerk (EN) gelieferten Signalen (u1, u2) die Eingangssignale für das Ausgangsnetzwerk (AN) erzeugen und wobei die Signalverarbeitungsfunktionen des Eingangs- (EN) und des Ausgangsnetzwerkes (AN) je nach der zu realisierenden Filterfunktion veränderbar sind, **dadurch gekennzeichnet, daß** das Ausgangsnetzwerk (AN) zwei kaskadierte Schaltungsteile (S1A, S2A) aufweist,
daß der erste Schaltungsteil (S1A) eine Abtastschaltung aufweist, mit der die Abtastfrequenz der Ausgangssignale (v1, v2) der Zweigfilter (F1, F2) veränderbar ist, und daß der zweite Schaltungsteil (S2A) eine Verknüpfungsschaltung mit folgender Funktion enthält:

$$y1(kT2) = a1^* \cdot e(kT2) + b2^* \cdot e2(kT2)$$

$$y2(kT2) = a2^* \cdot e2(kT2) \pm b1^* \cdot e1(kT2),$$

wobei e1(kT2) und e2(kT2) die Eingangssignale und y1(kT2) und y2(kT2) die Ausgangssignale des Verknüpfungsnetzwerkes sind, a1*, a2*, b1*, b2* veränderbare Parameter sind, T2 das Abtastintervall der Eingangssignale des Verknüpfungsnetzwerks und k ein laufender Zeitindex ist.

3. Digitaler Filterbaustein nach Anspruch 1 oder 2, **dadurch gekennzeichnet, daß** zwischen dem ersten (S1E, S1A) und zweiten (S2E, S2A) Schaltungsteil entweder des Eingangsnetzwerkes (EN) oder des Ausgangsnetzwerkes (AN) ein weiterer Schaltungsteil (S3) eingefügt ist, der in einem Verbindungszweig ein überbrückbares Verzögerungsglied (TV) aufweist.

4. Digitaler Filterbaustein nach Anspruch 1 oder 2, **dadurch gekennzeichnet, daß** die veränderbaren Parameter a1, a2, a1*, a2*, b1, b2, b1*, b2* die Werte 0, 1 oder -1 annehmen können, daß für eine Verschiebung der Frequenz der Signale am Filtereingang um eine Frequenz $f_0$ die Parameter a1, a2, b1, b2 folgende Werte annehmen:

$$a1 = a2 = a(kT1)$$

$$b1 = b2 = b(kT1),$$

wobei

$$a(kT1) = \cos(2\pi k f_0 / f_{AE})$$

$$b(kT1) = \pm \sin(2\pi k f_0 / f_{AE})$$

$$f_{AE} = 1/T1$$

ist
und daß für eine Verschiebung der Frequenz der Signale am Filterausgang um eine Frequenz $f_0^*$ die Parameter a1*, a2*, b1*, b2* folgende Werte annehmen

$$a1^* = a2^* = a^*(kT2)$$

$$b1^* = b2^* = b^*(kT2),$$

wobei

$$a^*(kT2) \;=\; \cos(2\pi kf_0{}^*/f_{AA})$$

$$b^*(kT2) \;=\; \sin(2\pi kf_0{}^*/f_{AA})$$

$$f_{AA} \;=\; 1/T2$$

ist.

**5.** Digitaler Filterbaustein nach einem der vorhergehenden Ansprüche, **dadurch gekennzeichnet, daß** die Zweigfilter (F1, F2) FIR Filter sind.

**6.** Digitaler Filterbaustein nach einem der vorhergehenden Ansprüche, **dadurch gekennzeichnet, daß** er Signaleingänge bzw. -ausgänge aufweist, über die weitere Filterbausteine in Kaskade schaltbar sind.

**7.** Digitaler Filterbaustein nach einem der vorhergehenden Ansprüche, **dadurch gekennzeichnet, daß** die Zweigfilter, das Eingangs- und das Ausgangsnetzwerk im Zeitmultiplex auf mehrere verschiedene Signale bzw. Kanäle umschaltbar sind.

**Claims**

**1.** A digital filter module comprising a plurality of digital branch filters (F1, F2), which are preceded by a digital input network (EN) and which are followed by a digital output network (AN), with the input network (EN) acting on one or more input signals (x1, x2) such that the branch filters (F1, F2) and the subsequent output network (AN) generate output signals (y1, y2) from these which correspond to one of a plurality of possible filter functions - for example: changes in the sampling frequency of the input signals, conversion of real input signals into complex-value output signals and vice versa, separation or assembly of input signals of different frequencies (filter diplexer), wherein the branch filters (F1, F2) generate the input signals for the output network (AN) independently from one another from the signals (u1, u2) supplied by the input network (EN), and wherein the signal processing functions of the input network (EN) and of the output network (AN) can be varied depending on the filter function to be realised, **characterised in that** the input network (EN) has two cascaded circuit parts (S1E, S2E); **in that** the first circuit part (S1E) contains a logic network with the following function:

$$c1(kT1) = a1 \cdot x1(kT1) \pm b2 \cdot x2(kT1)$$

$$c2(kT1) = a2 \cdot x2(kT1) \pm b1 \cdot x1(kT1),$$

wherein x1(kT1) and x2(kT1) are the input signals and c1(kT1) and c2(kT1) are the output signals of the logic network; a1, a2, b1, b2 are variable parameters with which the respective filter function can be set; T1 is the sampling interval of the input signals; and k is a running time index; and **in that** the second circuit part (S2E) has a sampling circuit with which the sampling frequency of the signals (u1, u2) supplied to the branch filters (F1, F2) can be varied.

**2.** A digital filter module comprising a plurality of digital branch filters (F1, F2), which are preceded by a digital input network (EN) and which are followed by a digital output network (AN), with the input network (EN) acting on one or more input signals (x1, x2) such that the branch filters (F1, F2) and the subsequent output network (AN) generate output signals (y1, y2) from these which correspond to one of a plurality of possible filter functions - for example: changes in the sampling frequency of the input signals, conversion of real input signals into complex-value output signals and vice versa, separation or assembly of input signals of different frequencies (filter diplexer), wherein the branch filters (F1, F2) generate the input signals for the output network (AN) independently from one another from the signals (u1, u2) supplied by the input network (EN), and wherein the signal processing functions of the input network (EN) and of the output network (AN) can be varied depending on the filter function to be realised,
**characterised in that** the output network (AN) has two cascaded circuit parts (S1A, S2A);
**in that** the first circuit part (S1A) has a sampling circuit with which the sampling frequency of the output signals (v1, v2) of the branch filters (F1, F2) can be varied;
and **in that** the second circuit part (S2A) contains a logic network with the following function:

$$y1(kT2) = a1^* \cdot e(kT2) \pm b2^* \cdot e2(kT2)$$

$$y2(kT2) = a2^* \cdot e2(kT2) \pm b1^* \cdot e1(kT2),$$

wherein e1(kT2) and e2(kT2) are the input signals and y1(kT2) and y2(kT2) are the output signals of the logic network; a1*, a2*, b1*, b2* are variable parameters; T2 is the sampling interval of the input signals of the logic network; and k is a running time index.

3.  A digital filter module in accordance with claim 1 or claim 2, **characterised in that** a further circuit part (S3), which has a bridgeable delay member (TV) in a connection branch, is inserted between the first circuit part (S1E, S1A) and the second circuit part (S2E, S2A) of either the input network (EN) or of the output network (AN).

4.  A digital filter module in accordance with claim 1 or claim 2, **characterised in that** the variable parameters a1, a2, a1*, a2*, b1, b2, b1*; b2* can adopt the values 0, 1 or -1; **in that** the parameters a1, a2, b1, b2 adopt the following values for a shift of the frequency of the signals at the filter input by a frequency $f_0$:

$$a1 = a2 = a(kT1)$$

$$b1 = b2 = b(kT1)$$

wherein

$$a(kT1) = \cos(2\pi k f_0 / f_{AE})$$

$$b(kT1) = \pm\sin(2\pi k f_0 / f_{AE})$$

$$f_{AE} = 1/T1;$$

and **in that** the parameters a1*, a2*, b1*, b2* adopt the following values for a shift of the frequency of the signals at the filter output by a frequency $f_0^*$:

$$a^*1 = a2^* = a^*(kT2)$$

$$b1^* = b2^* = b^*(kT2)$$

wherein

$$a^*(kT2) = \cos(2\pi kf_0^*/f_{AA})$$

$$b^*(kT2) = \pm\sin(2\pi kf_0^*/f_{AA})$$

$$f_{AA} = 1/T2.$$

**5.** A digital filter module in accordance with any one of the preceding claims, **characterised in that** the branch filters (F1, F2) are FIR filters.

**6.** A digital filter module in accordance with any one of the preceding claims, **characterised in that** it has signal inputs and signal outputs via which the further filter modules can be switched in cascade.

**7.** A digital filter module in accordance with any one of the preceding claims, **characterised in that** the branch filters, the input network and the output network can be switched to a plurality of different signals or channels in time multiplex.

**Revendications**

**1.** Composant de filtre numérique, comprenant plusieurs filtres ramifiés numériques (F1, F2) avant lesquels est branché un réseau d'entrée numérique (EN) et après lesquels est branché un réseau de sortie numérique (AN), le réseau d'entrée (EN) agissant sur un ou plusieurs signaux d'entrée (x1, x2) de telle façon que les filtres ramifiés (F1, F2) et le réseau de sortie (AN) qui s'y raccorde génèrent à partir de ces signaux des signaux de sortie (y1, y2) qui correspondent à une parmi plusieurs fonctions de filtre possibles, comme par exemple la modification de la fréquence de palpage des signaux d'entrée, la conversion de signaux d'entrée réels en signaux de sortie complexes ou inversement, la séparation ou le regroupement de signaux d'entrée de fréquences différentes (filtres à aiguillage), les filtres ramifiés (F1, F2) produisant indépendamment les uns des autres et à partir des signaux (u1, u2) fournis par le réseau d'entrée (EN), les signaux d'entrée pour le réseau de sortie (AN), et les fonctions de traitement de signal du réseau d'entrée (EN) et du réseau de sortie (AN) sont modifiables selon la fonction de filtre à réaliser, **caractérisé en ce que** le réseau d'entrée (EN) comprend deux parties de circuit en cascade (S1E, S2E), **en ce que** la première partie de circuit (S1E) contient un réseau de chaînage avec la fonction suivante :

$$c1(kT1) = a1 \cdot x1(kT1) \,\text{-/+}\, b2 \cdot x2(kT1)$$

$$c2(kT1) = a2 \cdot x2(kT1) \,\text{+/-}\, b1 \cdot x1(kT1)$$

dans laquelle x1 (kT1) et x2(kT1) sont les signaux d'entrée et c1(kT1) et c2(kT1) sont les signaux de sortie du réseau de chaînage, a1, a2, b1, b2 sont des paramètres modifiables au moyen desquels la fonction de filtre respective peut être réglée, T1 est l'intervalle de palpage des signaux d'entrée, et k est un indice temporel courant, et **en ce que** la deuxième partie de circuit (S2E) comprend un circuit de palpage au moyen duquel la fréquence de palpage des signaux (u1,u2) admis aux filtres ramifiés (F1, F2) est modifiable.

**2.** Composant de filtre numérique, comprenant plusieurs filtres ramifiés numériques (F1, F2) avant lesquels est branché un réseau d'entrée numérique (EN) et après lesquels est branché un réseau de sortie numérique (AN), le réseau d'entrée (EN) agissant sur un ou plusieurs signaux d'entrée (x1, x2) de telle façon que les filtres ramifiés (F1, F2) et le réseau de sortie (AN) qui s'y raccorde génèrent à partir de ces signaux des signaux de sortie (y1, y2) qui correspondent à une parmi plusieurs fonctions de filtre possibles, comme par exemple la modification de la fréquence de palpage des signaux d'entrée, la conversion de signaux d'entrée réels en signaux de sortie complexes ou inversement, la séparation ou le regroupement de signaux d'entrée de fréquences différentes (filtres à aiguillage), les filtres ramifiés (F1, F2) produisant indépendamment les uns des autres et à partir des signaux (u1, u2) fournis par le réseau d'entrée (EN), les signaux d'entrée pour le réseau de sortie (AN), et les fonctions de traitement de signal du réseau d'entrée (EN) et du réseau de sortie (AN) sont modifiables selon la fonction de filtre à réaliser, **caractérisé en ce que** le réseau de sortie (AN) comprend deux parties de circuit en cascade (S1A, S2A), **en ce que** la première partie de circuit (S1A) comprend un circuit de palpage au moyen duquel la fréquence de palpage des signaux de sortie (v1, v2) des filtres ramifiés (F1, F2) est modifiable.

**en ce que** la première partie de circuit (S2A) contient un réseau de chaînage avec la fonction suivante :

$$y1(kT2) = a1^* \cdot e1(kT2) \, {-/+} \, b2^* \cdot e2(kT2)$$

$$y2(kT2) = a2^* \cdot e2(kT2) \, {+/-} \, b1^* \cdot e1(kT2)$$

dans laquelle e1(kT2) et e2(kT2) sont les signaux d'entrée et y1 (kT2) et y2(kT2) sont les signaux de sortie du réseau de chaînage, a1*, a2*, b1*, b2* sont des paramètres modifiables, T2 est l'intervalle de palpage des signaux d'entrée, et k est un indice temporel courant.

3. Composant de filtre numérique selon la revendication 1 ou 2, **caractérisé en ce qu'**une autre partie de circuit (S3) est insérée entre la première partie de circuit (S1E, S1A) et la deuxième partie de circuit (S2E, S2A) soit du réseau d'entrée (EN) soit du réseau de sortie (AN), ladite autre partie de circuit comprenant un élément de retardement (TV) susceptible d'être by-passé, dans une ramification de liaison.

4. Composant de filtre numérique selon la revendication 1 ou 2, **caractérisé en ce que** les paramètres modifiables a1, a2, a1*, a2*, b1, b2, b1*, b2* peuvent prendre les valeurs 0, 1 ou - 1, **en ce que** pour un décalage de la fréquence des signaux à l'entrée de filtre à raison d'une fréquence $f_0$, les paramètres a1, a2, b1, b2 prennent les valeurs suivantes :

$$a1 = a2 = a(kT1)$$

$$b1 = b2 = b(kT1)$$

dans lesquelles

$$a(kT1) = \cos(2\pi k f_0/f_{AE})$$

$$b(kT1) = \pm \sin(2\pi k f_0/f_{AE})$$

$$f_{AE} = 1/T1$$

et **en ce que** pour un décalage de la fréquence des signaux à la sortie de filtre à raison d'une fréquence $f_0^*$, les paramètres a1*, a2*, b1*, b2* prennent les valeurs suivantes :

$$a1^* = a2^* = a^*(kT2)$$

$$b1* = b2* = b*(kT2)$$

dans lesquelles

$$a*(kT2) = \cos(2\pi kf_0*/f_{AA})$$

$$b*(kT2) = \sin(2\pi kf_0*/f_{AA})$$

$$f_{AA} = 1/T2.$$

5. Composant de filtre numérique selon l'une des revendications précédentes, **caractérisé en ce que** les filtres ramifiés (F1, F2) sont des filtres FIR.

6. Composant de filtre numérique selon l'une des revendications précédentes, **caractérisé en ce qu'**il comprend des entrées de signaux et respectivement des sortie de signaux, via lesquelles les autres composants de filtre peuvent être branchés en cascade.

7. Composant de filtre numérique selon l'une des revendications précédentes, **caractérisé en ce que** les filtres ramifiés, le réseau d'entrée, et le réseau de sortie peuvent être basculés en multiplex temporel vers plusieurs signaux ou canaux différents.

Fig.1

Fig 2

Fig. 3